Europäisches Patentamt

European Patent Office

Office européen des brevets

(11) Publication number: **0 138 602 B1**

# EUROPEAN PATENT SPECIFICATION

(45) Date of publication of patent specification: **04.03.92**  (51) Int. Cl.5: **G03B 41/00**, G03F 7/20

(21) Application number: **84307030.1**

(22) Date of filing: **15.10.84**

(54) Method of fabricating a photomask pattern.

(30) Priority: **17.10.83 JP 194580/83**

(43) Date of publication of application:
**24.04.85 Bulletin 85/17**

(45) Publication of the grant of the patent:
**04.03.92 Bulletin 92/10**

(84) Designated Contracting States:
**DE FR GB**

(56) References cited:
**US-A- 4 388 386**

**PATENT ABSTRACTS OF JAPAN, vol. 5, no. 3 (E-40)[675], 10th January 1981 & JP-A-55-134 934**

**PATENT ABSTRACTS OF JAPAN, vol. 6, no. 247 (E-146)[1125], 7th December 1982 & JP-A-57-148 347**

**PATENT ABSTRACTS OF JAPAN, vol. 7, no. 180 (P-215)[1325], 9th August 1983 & JP-A-58-83 853**

(73) Proprietor: **FUJITSU LIMITED**
**1015, Kamikodanaka Nakahara-ku**
**Kawasaki-shi Kanagawa 211(JP)**

(72) Inventor: **Araihara, Satoshi c/o Fujitsu Limited**
**Patent Department 1015 Kamikodanaka**
**Nakahara-ku**
**Kawasaki-shi Kanagawa 211(JP)**

(74) Representative: **Sunderland, James Harry et al**
**HASELTINE LAKE & CO Hazlitt House 28**
**Southampton Buildings Chancery Lane**
**London WC2A 1AT(GB)**

Rank Xerox (UK) Business Services

## Description

The present invention relates to a method of fabricating a photomask pattern for example for use in the fabrication of a semiconductor device such as an integrated circuit (IC) or a large scale integrated circuit (LSI).

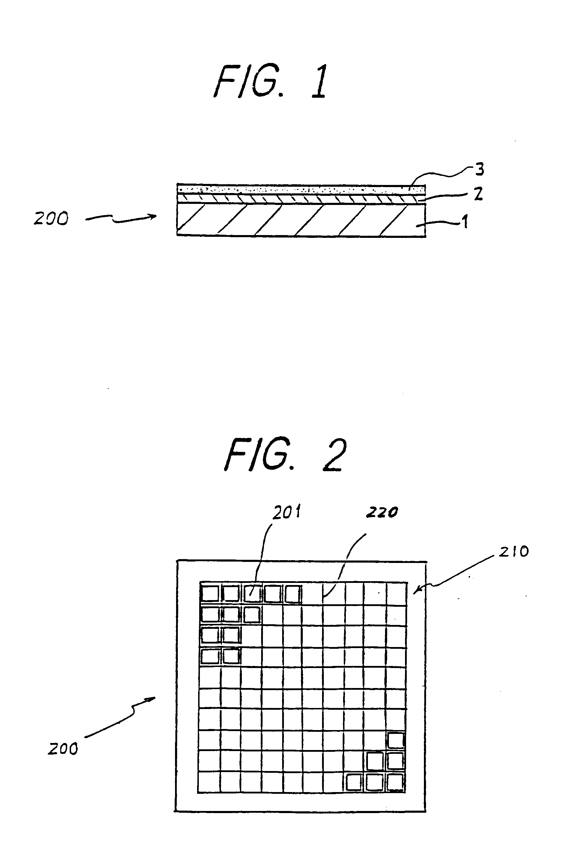

A photomask is made of a base plate of silica glass on which a metal layer and a photoresist layer are sputtered and coated as shown in Fig. 1. Fig. 1 gives a schematic cross-sectional view of a photomask 200: a metal layer 2 of chromium is sputtered on a glass plate 1 and photoresist layer 3 is coated on the metal layer 2. A photomask pattern is fabricated by processes involving exposing the photomask to an optical image, developing and etching the photomask. Fig. 2 gives a schematic plan view of a photomask 200 on which a photomask pattern 210 has been printed. The photomask pattern 210 consists of plurality of unit patterns 201 separated by scribe lines 220. Each unit pattern 201 is of the same shape and size, and corresponds for example to a pattern for a semiconductor die: in this case the photomask pattern 210 is for mass production of semiconductor devices.

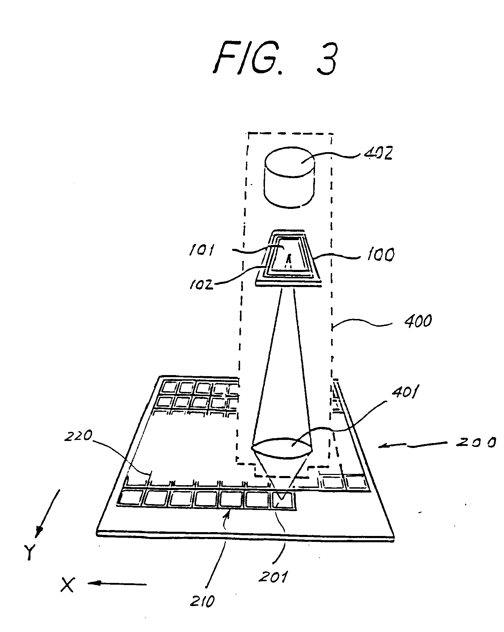

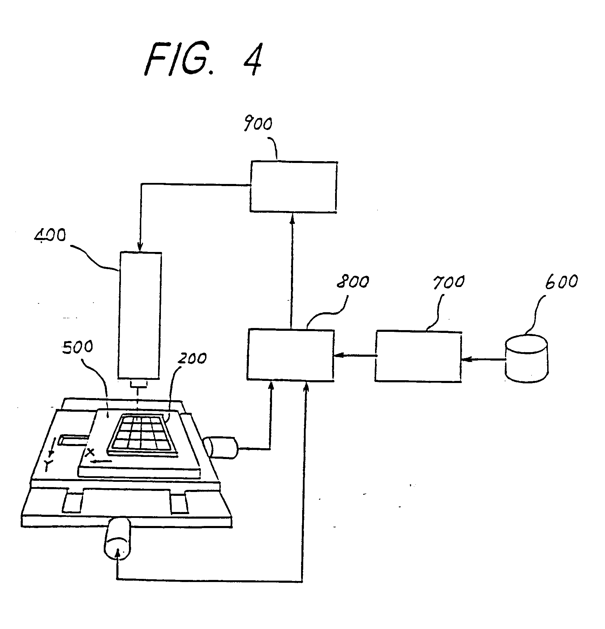

Fig. 3 schematically illustrates a printing process for forming a photomask pattern. Each unit pattern 201 is printed by exposing the photomask 200 to an optical image of a reticle pattern 101 on a reticle 100 by means of an optical system 400. The reticle pattern 101 is a mother pattern for example for a semiconductor die and the size of the reticle pattern is as large as 10 times of that of an exposed unit pattern 201 on the photomask, to provide for high accuracy printing. Thus, the optical system 400 has a lens 401 having a reduction factor of one tenth. 402 is a light source of the optical system. The unit patterns 201 are printed in turn, one by one, shifting the photomask 200 in X and Y directions with respect to fixed optical system 400. This is called "step-and-repeat printing". Apparatus for step-and-repeat printing will be explained in more detail with reference to Fig. 4.

Fig. 4 is a schematic block diagram of an example of a step-and-repeat printing apparatus. In Fig. 4, a photomask 200 is mounted on a stage 500 which is shifted in X and Y directions under control of a stage controller 800. The sequence of the step-and-repeat printing (the sequence in which unit patterns are printed on the photomask) is determined in advance and stored in a memory 600. Data in the memory 600 is read out and amplified by an amplifier 700 and goes to the stage controller 800. The data fed to the stage controller 800 controls stage movement and also controls a light controller 900 which controls on-off switching of the light source 402 of optical system 400 as shown in Fig. 3 in synchronism with the step-and-repeat movement of the stage 500.

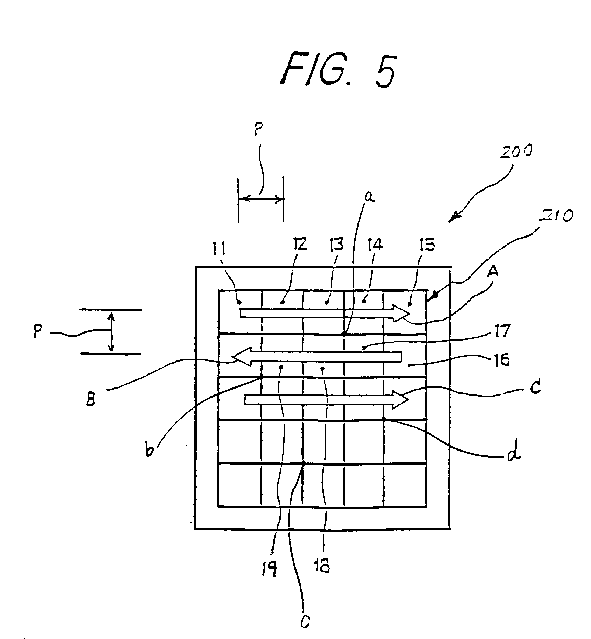

Fig. 5 is a schematic diagram illustrating the sequence of step-and-repeat printing as previously employed, showing an arrangment of unit patterns in a matrix having rows and columns on a photomask pattern area of a photomask. The step-and-repeat printing is performed (successive exposures of the photomask to the reticle pattern, to form successive unit patterns, are performed) so that the exposure of unit patterns advances from a leftmost matrix element 11 to matrix elements 12, 13, ... sequentially in turn in a rightwards direction in Fig. 5 along a first row of the matrix, as shown by arrow A in Fig. 5. When exposure of unit patterns in the first row is finished, exposure is shifted down and proceeds to a rightmost matrix element 16 in the second row of the matrix and then advances leftwards as shown by arrow B. Thus, exposure of unit patterns advances through the matrix in a zigzag pattern as shown by arrows A, B, C,... with a succession of step-and-repeat exposures effected with equal pitches "P" in row and column directions.

Semiconductor circuitry tends to be complicated, and a plurality of photomasks are required to fabricate a semiconductor device (IC) from a wafer. The position of a unit pattern on one photomask must properly coincide with the position of a unit pattern on another photomask when they are overlapped to make up the pattern of the IC device. Therefore, the unit patterns on a photomask, especially the positions of the unit patterns, must be carefully inspected after printing of the photomask, to ensure that the photomask is satisfactory for use in semiconductor device (IC) fabrication. The inspection is performed by observing through a microscope vernier patterns printed together with each unit pattern on the photomask.

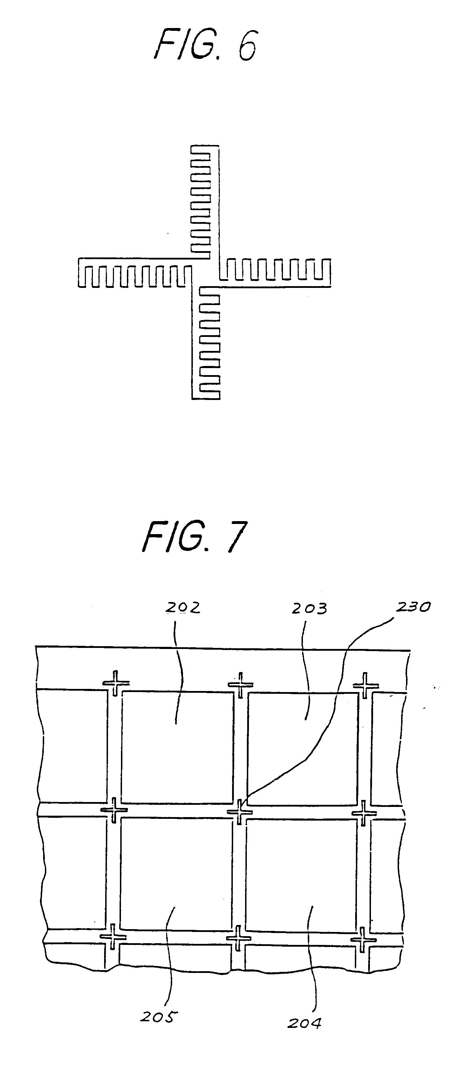

Fig. 6 shows an example of a vernier pattern, a cross-shaped vernier pattern, which has four branches-top, bottom, left and right. Each branch is like a comb in form. The numbers of teeth in top and bottom branches differ by one, and the numbers of teeth in left and right branches differ by one. This difference of one tooth between branches provides for vernier measurement when branches with different tooth numbers are combined.

In the reticle pattern used to form unit patterns mother patterns for vernier patterns are provided at its four corners so that the numbers of teeth at top and bottom and left and right branches become opposite in cross-shaped vernier patterns placed diagonally to each other. For example, in two vernier patterns at diagonally opposite corners of a unit pattern, the numbers of teeth in opposite branches of one vernier pattern are transposed with respect to the numbers of teeth in the corresponding opposite branches of the other vernier pattern.

Vernier patterns of adjacent unit patterns formed on a photomask overlap each other when they are printed on the photomask.

Fig. 7 schematically illustrates this situation. For example, a pattern 230 is formed by overlapping vernier patterns of unit patterns 202, 203, 204, and 205.

This overlapping of vernier patterns allows shear of unit patterns which are printed adjacent to each other to be measured by observing pattern 230. (That is, displacement or departure from regular printing pitch, hence incorrect unit pattern printing, e.g. incorrect unit pattern positioning, can be measured.)

This kind of pattern 230 will be called an "overlapped vernier pattern" hereinafter.

As there can be as many as several thousand unit patterns on a photomask in some cases, it is in practice impossible to measure shear for all the overlapped vernier patterns.

However, it is well known in the art of inspection that inspection only at several points on a photomask is sufficient.

For example, inspection of four points each placed near a middle part of a respective one of the four sides of the photomask pattern as shown by points a, b, c, and d in Fig. 5 is sufficient inspection of positions of unit patterns on the photomask pattern.

Thus, in the previous method of fabricating a photomask pattern, step-and-repeat printing as explained above is effected to print all the unit patterns on the photomask, and vernier patterns are inspected at chosen locations on the photomask.

According to the present invention there is provided a method of fabricating a photomask pattern, comprising an array of unit patterns, on a photomask pattern area of a photomask plate, each unit pattern having a vernier pattern such that when the photomask pattern is fabricated vernier patterns of respective adjacent unit patterns register with one another so as to provide for vernier measurement of shear,

comprising 2 exposure modes where

in one exposure mode, exposing at least one selected array location to an optical image for forming a unit pattern, and

in another exposure mode, exposing the other array locations one by one in turn to the optical image for forming the unit pattern, in a regular ordered sequence,

such that registering vernier patterns of adjacent unit patterns respectively provided by exposures in the one and other exposure modes provide for measurement of accumulated shear which occurs, primarily in the regular ordered sequence of exposures of the other exposure mode.

The present invention overcomes problems which have been determined to occur with the previous method of fabricating a photomask pattern as explained above.

First, to enable a better understanding of the present invention, problems determined to occur with the previous method of photomask pattern fabrication as described with reference to Figs. 1 to 7 will be explained.

1. Printing shear accumulates as unit pattern exposures are advanced in steps along a row of unit patterns, for example as shown by the arrows A, B, or C in Fig. 5.

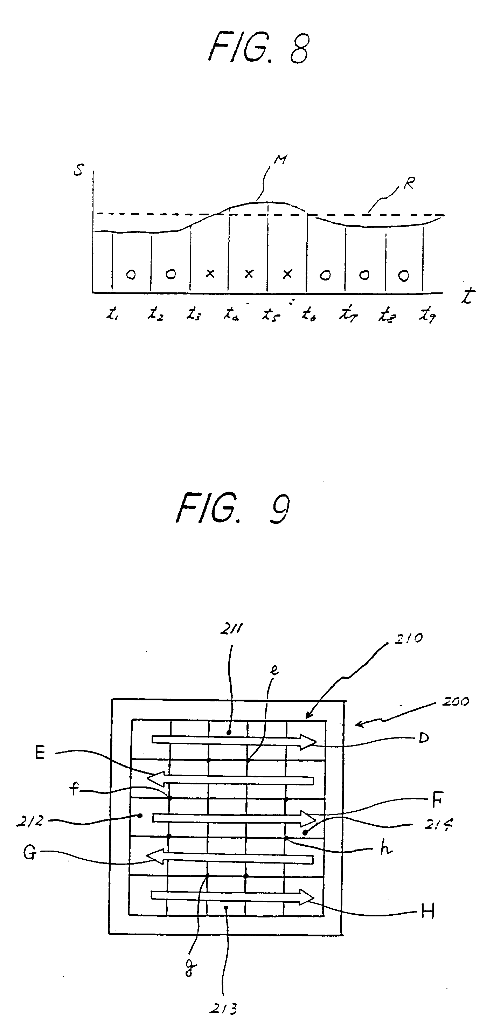

2. The shear accumulation arises from electrical and mechanical causes which depend on features of the printing apparatus used, and at unpredictable intervals the shear may accumulate to unacceptibly high values as illustrated in Fig. 8.

Fig. 8 is a graph in which the abscissa t represents time at which a photomask pattern exposure is carried out, and the ordinate s represent a maximum amount of shear measured for an exposure at the relevent time. Absolute values of shear are represented by s, obtained by measuring the shear in a photomask pattern. Broken line R indicates an allowable maximum value of shear (displacement) from ideal positioning of a unit pattern. The curve M shows actually occurring amounts of shear. In the Figure, $t_1$, $t_2$ ..., $t_9$ show points in time. If it is assumed that the exposure of the whole unit patterns (if it is assumed that exposure of all the unit patterns on a photomask pattern) is done in a time interval from $t_1$ to $t_2$, or from $t_2$ to $t_3$, ..., or from $t_8$ to $t_9$, exposures performed in the intervals from $t_1$ to $t_2$, $t_2$ to $t_3$, $t_6$ to $t_7$, $t_7$ to $t_8$ and $t_8$ to $t_9$ (in relation to which respective indications "0" are given) result in good printing (shear less than allowable maximum), but exposures performed in the time intervals from $t_3$ to $t_4$, $t_4$ to $t_5$ or $t_5$ to $t_6$ (in relation to which respective indications "x" are given) result in bad printing (shear more than allowable maximum). The time interval required for the exposure (for the exposure of all unit patterns on a photomask pattern) is several tens of minutes, and time intervals in which shear begins to exceed the allowable maximum amount R occur with a frequency of several house.

3. It is impossible to detect such printing shear which exceeds the allowable maximum R by observing and measuring vernier patterns with the previous method of photomask pattern fabrication, because each unit pattern has an amount of accumulated shear which will be almost equal to the amounts of accumulated shear suffered by adjacent unit patterns. Examination of overlapped vernier patterns (formed by the vernier patterns of adjacent unit patterns) will reveal only relative shear of the adjacent unit patterns, which will normally be small. Zero deviation (deviation from zero shear) of the vernier does not show absolute zero deviation.

4. Absolute amounts of shear can be measured using a laser measuring system. However it takes a great deal of time to carry out such measurements, for example time is needed for optical setting of the system. Therefore, whilst laser measurement is used in the laboratory it is not practical for use in day-to-day manufacture. Vernier pattern measurement is still used in actual fabrication of photomask patterns.

An embodiment of the present invention provides a method of fabricating a photomask pattern having a plurality of unit patterns, corresponding for example to semiconductor dies, such that accumulated printing shear, which occurs in the course of step-and-repeat exposures in the process for printing the unit patterns, and which has been impossible to detect by previous methods suitable for actual manufacture (rather than merely laboratory methods), can be measured using vernier patterns belonging to the unit patterns.

Briefly, in an embodiment of the present invention, two exposure modes are used in the printing process for printing the unit patterns on a photomask.

First, in a process for printing unit patterns in a matrix having rows and columns (each unit pattern corresponding to a matrix element), some selected matrix elements placed as far as possible from one another in the photomask pattern area are exposed to the optical image of a unit pattern (with associated vernier patterns).

Second, after the above exposures, exposures of the optical image are carried out in a step-and-repeat fashion along each row. That is, exposures to form unit patterns are advanced one by one continuously through the matrix elements along a row of a matrix, then proceed to a next row and so on in a zigzag pattern row by row from end to end of the photomask pattern area.

With exposures carried out in first or second stages or modes as set forth above, the difference between the shear of a unit pattern exposed in the first stage and that of a neighboring unit pattern exposed in the second stage appears very largely because of shear accumulation during the second exposure stage. Thus, employing an embodiment of the present invention for photomask pattern fabrication, accumulated printing shear becomes detectable using the vernier patterns.

As semiconductor devices become more complicated, many photomask are required to fabricate such semiconductor devices on a wafer. By applying an embodiment of the present invention to the fabrication of each photomask, inspection of each photomask more certainly enables the suitability of the photomask to be determined, which contributes greatly to reductions in time required for semiconductor device fabrication and in the cost of semiconductor devices. An embodiment of the present invention also facilitates increases in reliability of semiconductor devices.

Reference is made, by way of example, to the accompanying drawings, in which:-

Fig. 1 is a schematic cross-sectional view of a photomask,

Fig. 2 is schematic plan view of a photomask with unit patterns thereon,

Fig. 3 is a schematic perspective diagram illustrating fabrication of a photomask pattern on a photomask,

Fig. 4 is a schematic block diagram of apparatus for photomask pattern fabrication illustrating elements controlling devices shown in Fig. 3,

Fig. 5 is a schematic diagram illustrating the sequence of printing of unit patterns in a matrix in a photomask pattern area of a photomask as previously effected,

Fig. 6 schematically illustrates a cross-shaped vernier pattern used for measurement of shear of unit patterns in a photomask pattern,

Fig. 7 is a schematic plan view diagram showing unit patterns printed in a photomask pattern area of a photomask with overlapped vernier patterns,

Fig. 8 is a graph illustrating time variation of accumulated shear as occurs with apparatus for photomask printing, and

Fig. 9 is a schematic diagram for explanation of sequence of printing of unit patterns in a matrix in a photomask pattern area of a photomask in accordance with the present invention.

Fig. 9 schematically illustrates a photomask pattern to which a method of fabrication embodying the present invention is applied. The Figure illustrates a matrix corresponding to the arrangement of a plurality of unit patterns on a photomask pattern area of a photomask 200. Parts in the Figure divided by horizontal and vertical lines, having a checked pattern, are matrix elements corresponding to respective unit patterns. Each matrix element is to be exposed to an optical image for forming a unit pattern including four vernier patterns placed at respective corners of the unit pattern. Exposures are effected in the following two exposure stages or modes:

first, exposures are respectively carried out on selected matrix elements 211, 212, 213, and 214, located at middle parts of respective ones of the four side edges of the area to be occupied by a photomask pattern 210 (the photomask pattern area); These exposures will be called the "first exposure mode" hereinafter; and

second, exposures are carried out for other matrix elements by step-and-repeat exposures along successive rows of the matrix, row by row in a zigzag pattern as shown by arrows D, E, F, G, and H Fig. 9 (matrix elements exposed in the first exposure mode are not exposed in the second exposure mode); These exposures will be called the "second exposure mode" hereinafter.

The first an second exposure modes are effected using printing apparatus as shown in Fig. 4 for example using a suitable program for controlling the exposure modes previously stored in the memory 600.

After printing, the positions of the unit patterns in the photomask pattern 210 are inspected by observing overlapped vernier patterns at selected points as shown by points such as e, f, g, and h in Fig. 9. Overlapped vernier patterns at these points are formed by the overlap of unit patterns formed in different exposure modes, i.e. in the first and second exposure modes, and accumulated shear can be certainly detected. This is because the vernier patterns printed in the first exposure mode are printed in quite a different time slot from vernier patterns printed in the second exposure mode. That is, in the first exposure mode, there is (substantially) no accumulated shear in the selected unit patterns 211, 212, 213 and 214. On the other hand, in the second exposure mode, shear accumulates in the course of the step-and-repeat procedure used.

The exposures effected in the first exposure mode need not always be made at middle parts of the side edges of the photomask pattern area. They can be effected at locations spaced far apart, e.g. as far as possible apart, from one another in the photomask pattern area. To make the detection of accumulated shear in the photomask pattern possible, it is only required that overlapped vernier patterns should be provided by vernier patterns printed in different exposure modes.

The first and second exposure modes can be carried out in reverse order (i.e. second mode before first mode).

If unit pattern exposures were effected in a random order instead of in an ordered step-and-repeat sequence along rows, accumulated shear could be detected and there would be no need to provide two exposure modes as explained above. However, random exposure is not practically applicable because it would require a great deal of complicated work and time to provide a suitable exposure control program, and further, great care would have to be taken to avoid occurrence of soft errors on photomasks. This would cause an increase in fabrication cost and would reduce reliability of photomask fabrication. Consequently, the use of two exposure modes as explained above, utilizing step-and-repeat exposures along rows in the second exposure mode is more practical for photomask fabrication.

An embodiment of the present invention provides a method for fabricating unit patterns each having the same shape and size, and each corresponding to a semiconductor die for example, on a photomask pattern area of a photomask. Designating a matrix having rows and columns for the unit patterns on the photomask pattern area, fabrication is effected with two exposure mode. In a first exposure mode, several selected matrix elements placed as far as possible from one another in the photomask pattern area are exposed to a unit pattern optical image. In the second exposure mode, matrix elements (except the elements exposed to be exposed in the first exposure mode) are exposed to the unit pattern optical image in turn matrix element row by matrix element row. The unit pattern includes vernier patterns which produce overlapped vernier patterns when the exposures of the first and the second exposure modes are effected, so, after all unit patterns have been printed on the photomask base plate, an inspection of positions of the unit patterns can be made by observing some of the overlapped vernier patterns to measure accumulated shear produced in the second exposure mode.

**Claims**

1. A method of fabricating a photomask pattern, comprising an array of unit patterns, on a photomask pattern area of a photomask plate, each unit pattern having a vernier pattern such that when the photomask pattern is fabricated vernier patterns of respective adjacent unit patterns register with one another so as to provide for vernier measurement of shear,

   comprising two exposure modes where

   in one exposure mode, exposing at least one selected array location to an optical image for forming a unit pattern, and

   in another exposure mode, exposing the other array locations one by one in turn to the optical image for forming the unit pattern, in a regular ordered sequence,

   such that registering vernier patterns of adjacent unit patterns respectively provided by exposures in the one and other exposure modes provide for measurement of accumulated shear which occurs, primarily in the regular ordered sequence of exposures of the other exposure mode.

2. A method as claimed in claim 1, wherein, in the one exposure mode, a plurality of selected array locations, spaced apart from one another, are exposed to the said optical image.

3. A method as claimed in claim 2, wherein the selected array locations are spaced as far as possible apart from one another within the photomask pattern area.

4. A method as claimed in any preceding claim, wherein the array is a matrix array, with matrix elements, in rows and columns, corresponding to array locations, and wherein the said regular ordered sequence involves step-and-repeat shifting, element by element through each row of matrix elements, row by row.

5. A method as claimed in claim 4, wherein the step-and-repeat goes from row to adjacent row in a zigzag pattern.

6. A method as claimed in claim 4 or claim 5, wherein the selected array locations correspond to four positions on the matrix array, placed at the middle parts of the respective four side edges of the matrix array.

7. A method as claimed in any preceding claim, wherein the said one exposure mode is carried out before the other exposure mode.

8. A method as claimed in any preceding claim, wherein each unit pattern has four cross-shaped vernier patterns placed respectively at each of the four corners of the unit pattern.

## Revendications

1. Procédé de fabrication d'un dessin de masque photographique, comprenant une matrice de motifs élémentaires, sur une zone de dessin de masque photographique formée sur une plaque d'un masque photographique, chaque motif élémentaire ayant un dessin de vernier de manière que, lorsque le dessin du masque photographique est réalisé, les dessins de vernier des motifs élémentaires adjacents respectifs soient positionnés mutuellement et permettent une mesure du décalage à l'aide d'un vernier,

comprenant deux modes d'exposition tels que

dans un premier mode d'exposition, un emplacement choisi au moins de la matrice est exposé à une image optique permettant la formation d'un motif élémentaire, et

dans un autre mode d'exposition, les autres emplacements de la matrice sont exposés un à un et tour à tour à l'image optique destinée à former le motif élémentaire, suivant une séquence ordonnée régulière,

si bien que le positionnement des dessins de vernier de motifs élémentaires adjacents formés par les expositions dans le premier mode et dans l'autre mode d'exposition permet la mesure du décalage cumulé qui est produit, essentiellement au cours de la séquence ordonnée régulière d'expositions de l'autre mode d'exposition.

2. Procédé selon la revendication 1, dans lequel, dans le premier mode d'exposition, plusieurs emplacements choisis de la matrice, séparés les uns des autres, sont exposés à l'image optique.

3. Procédé selon la revendication 2, dans lequel les emplacements choisis de la matrice sont aussi éloignés que possible les uns des autres dans la zone du dessin du masque.

4. Procédé selon l'une quelconque des revendications précédentes, dans lequel la matrice est bidimensionnelle, les éléments de la matrice, en lignes et en colonnes, correspondant aux emplacements de la matrice, et la séquence ordonnée régulière comprend un décalage par étapes et répétition, élément par élément dans chaque ligne d'éléments, et ligne par ligne.

5. Procédé selon la revendication 4, dans lequel le traitement par étapes et répétition est réalisé d'une ligne à une ligne suivante suivant un dessin sinueux.

6. Procédé selon la revendication 4 ou 5, dans lequel les emplacements choisis de la matrice correspondent à quatre positions sur la matrice, disposées dans les parties médianes des quatre côtés respectifs de la matrice.

7. Procédé selon l'une quelconque des revendications précédentes, dans lequel le premier mode d'exposition est exécuté avant l'autre mode d'exposition.

8. Procédé selon l'une quelconque des revendications précédentes, dans lequel chaque motif élémentaire a quatre dessins de vernier en forme de croix, placés respectivement à chacun des quatre coins du motif élémentaire.

## Patentansprüche

1. Verfahren zur Herstellung eines Fotomaskenmusters, das eine Anordnung von Einheitsmustern umfaßt, auf einer Fotomaskenmusterfläche einer Fotomaskenplatte, wobei jedes Einheitsmuster ein Noniusmuster besitzt, so daß bei der Herstellung des Fotomaskenmusters Noniusmuster jeweilig benachbarter Einheitsmuster miteinander ausgerichtet werden, um so eine Noniusmessung der Scherung zu ermöglichen,

das zwei Belichtungsarten umfaßt,

wobei in einer Belichtungsart, mindestens eine ausgewählte Anordnungsstelle mit einem optischen Bild zur Bildung eines Einheitsmusters belichtet wird, und

in einer anderen Belichtungsart, die anderen Anordnungsstellen nacheinander mit dem optischen Bild zur Bildung des Einheitsmusters belichtet werden, in einer regelmäßig geordneten Folge, so daß die Ausrichtung der Noniusmuster, jeweils benachbarter Einheitsmuster, die durch Belichtungen in der einen und der anderen Belichtungsart bereitgestellt wurden, die Messung angehäufter Scherung liefert, die hauptsächlich in der regelmäßig geordneten Abfolge von Belichtungen in der anderen Belichtungsart erfolgt.

2. Verfahren nach Anspruch 1, in dem in der einen Belichtungsart eine Vielzahl ausgewählter, mit Abstand voneinander angeordneten Anordnungsstellen mit dem optischen Bild belichtet werden.

3. Verfahren nach Anspruch 2, in dem die ausgewählten Anordnungsstellen so weit wie möglich voneinander mit Abstand auf der Fotomaskenmusterfläche angeordnet sind.

4. Verfahren nach einem der vorhergehenden Ansprüche, bei dem die Anordnung eine Matrixanordnung ist, mit Matrixelementen, in Zeilen und Spalten, die den Anordnungsstellen entsprechen, und bei dem die regelmäßig geordnete Abfolge Schritt-und-Wiederhol-Verschiebung beinhaltet, Element für Element durch jede Zeile von Matrixelementen, Zeile für Zeile.

5. Verfahren nach Anspruch 4, bei dem das Schritt-und Wiederhol-Verschieben von einer Zeile zur nächsten in einem Zickzackmuster verläuft.

6. Verfahren nach Anspruch 4 oder 5, bei dem die ausgewählten Anordnungsstellen vier Stellen auf der Matrixanordnung entsprechen, die in den Mittelteilen der jeweiligen vier Seitenränder der Matrixanordnung liegen.

7. Verfahren nach einem der vorhergehenden Ansprüche, bei dem die eine Belichtungsart vor der anderen Belichtungsart durchgeführt wird.

8. Verfahren nach einem der vorhergehenden Ansprüche, bei dem jedes Einheitsmuster vier kreuzförmige Noniusmuster besitzt, die jeweils in jeder der vier Ecken des Einheitsmusters liegen.

# FIG. 1

# FIG. 2

# FIG. 3

# FIG. 4

# FIG. 5

## FIG. 6

## FIG. 7

# FIG. 8

# FIG. 9